# FASCICULE DE BREVET EUROPEEN

(11) **EP 3 498 610 B1**
(45) Date de publication et mention de la délivrance du brevet: **18.03.2020**
(21) Numéro de dépôt: 18211828.1
(22) Date de dépôt: 12.12.2018
(51) Int. Cl.: B64D 45/00, A45C 11/00

(54) **PLATEFORME D'ACCUEIL POUR ACCUEILLIR UN DISPOSITIF ÉLECTRONIQUE PORTABLE DANS UN AÉRONEF**
AUFNAHMEPLATTFORM FÜR DIE AUFNAHME EINER TRAGBAREN ELEKTRONISCHEN VORRICHTUNG IN EINEM LUFTFAHRZEUG
DOCKING PLATFORM FOR HOUSING A PORTABLE ELECTRONIC DEVICE IN AN AIRCRAFT

(30) Priorité: 18.12.2017 FR 1762320
(43) Date de publication de la demande: 19.06.2019
(73) Titulaire: Airbus Operations (S.A.S.), 31060 Toulouse (FR)
(72) Inventeur: CORBEFIN, Jean-Philippe, 31700 Mondonville (FR)
(74) Mandataire: Sarraméa, Claude

(56) Documents cités:
- EP-A1- 2 301 314
- EP-A2- 2 647 410
- WO-A2-2008/154311
- CA-A1- 2 968 385
- DE-U1-202013 008 889
- US-A1- 2014 209 332
- US-A1- 2017 099 074
- Anonymous - Nickname Flying Cabbage: "Low Hour PPL < Flying Cabbage", , 12 avril 2011 (2011-04-12), XP055485354, Extrait de l'Internet: URL:https://blog.spiteri.com/category/low- hour-ppl/ [extrait le 2018-06-18]

## Description

La présente invention concerne le domaine de l'utilisation de dispositifs électroniques portables dans un aéronef, en particulier dans un cockpit d'aéronef. De tels dispositifs électroniques portables, par exemple de type EFB (« Electronic Flight Bag » en anglais) sont utilisés fréquemment par des membres d'équipage dans le cockpit. Ces EFB correspondent parfois à des tablettes tactiles alimentées par des batteries intégrées dans lesdites tablettes. Ces tablettes sont généralement fournies aux membres d'équipage par la compagnie aérienne exploitant l'aéronef. Elles ne correspondent alors pas à des matériels certifiés par les autorités de certification aérienne. Parfois, les membres d'équipage sont également amenés à introduire dans le cockpit des téléphones intelligents personnels (« smartphone » en anglais), également alimentés par batteries. Or, il est connu que les batteries alimentant les téléphones portables intelligents ou les tablettes peuvent parfois présenter un risque d'incendie, en particulier les batteries comportant du lithium. Il existe donc un besoin de protéger l'aéronef d'un risque d'incendie dû à de tels dispositifs électroniques portables, tout en permettant l'utilisation desdits dispositifs.

Le document « Nickname Flying Cabbage : Low Hour PPL Flying Cabbage » extrait de l'internet (https://blog.spiteri.com/category/low-hour-ppl) décrit un boitier transparent contenant une caméra. Ce boitier est maintenu de façon provisoire sur le tableau de bord d'un cockpit d'aéronef au moyen de deux serre-joints, pour faire un test d'enregistrement vidéo au moyen de ladite caméra. Toutefois, un tel boitier n'est pas adapté pour recevoir un EFB et encore moins pour permettre à un utilisateur d'interagir avec cet EFB. De plus, un maintien au moyen de serre-joints relève du bricolage. Même s'il peut être approprié pour un test, il n'est pas envisageable pour une application dans un aéronef exploité par une compagnie aérienne.

Le document US2017/099074A1 décrit un boitier de protection pour un dispositif électronique portable.

### EXPOSE DE L'INVENTION :

La présente invention a notamment pour but d'apporter une solution à ce besoin. Elle concerne une plateforme d'accueil pour accueillir un dispositif électronique portable dans un aéronef, en particulier dans un cockpit de l'aéronef, la plateforme d'accueil étant prévue pour être fixée dans l'aéronef.

La plateforme d'accueil comporte un moyen de fermeture étanche à l'air configuré pour occuper au moins une première position, dite ouverte, dans laquelle le dispositif électronique portable peut être inséré ou retiré de la plateforme d'accueil et, une deuxième position, dite fermée, dans laquelle le dispositif électronique portable peut être utilisé par un utilisateur dans l'aéronef, en particulier dans le cockpit de l'aéronef, lorsque le dispositif électronique portable est inséré dans la plateforme d'accueil, la plateforme d'accueil étant fixée dans l'aéronef, en particulier dans le cockpit de l'aéronef.

La plateforme d'accueil est remarquable en ce qu'elle comporte un système de ventilation commandable entre une première position, dite active, dans laquelle le système de ventilation permet une circulation d'air entre l'intérieur et l'extérieur de la plateforme d'accueil et une deuxième position, dite inactive, dans laquelle le système de ventilation empêche la circulation d'air entre l'intérieur et l'extérieur de la plateforme d'accueil.

La plateforme d'accueil permet ainsi à un utilisateur d'un dispositif électronique portable de placer ce dispositif électronique portable à l'intérieur de la plateforme d'accueil, puis de placer le moyen de fermeture dans la position fermée pour utiliser le dispositif électronique portable. Ainsi, le dispositif électronique portable est placé dans la plateforme d'accueil fermée de façon étanche à l'air lorsque l'utilisateur utilise ce dispositif électronique portable. Cela permet de protéger l'aéronef, en particulier le cockpit de l'aéronef, et les membres d'équipage en cas d'incendie et/ou d'émanation de fumées provenant du dispositif électronique portable. Le système de ventilation permet d'évacuer la chaleur issue du dispositif électronique portable.

Selon une première variante, le système de ventilation comporte un moyen mécanique prévu pour commander manuellement une commutation entre sa position active et sa position inactive ou réciproquement.

Selon une deuxième variante, le système de ventilation comporte :
- un capteur prévu pour détecter une condition environnementale dégradée à l'intérieur de la plateforme d'accueil ;
- un actionneur configuré pour commander la position active ou la position inactive du système de ventilation ; et
- une unité de traitement reliée à une sortie du capteur et configurée pour commander l'actionneur de façon à commander la position active du système de ventilation lorsque le capteur détecte une condition environnementale dégradée.

Dans un mode particulier de réalisation, la plateforme d'accueil comporte un échangeur de chaleur prévu pour évacuer la chaleur issue du dispositif électronique portable vers l'extérieur de la plateforme d'accueil. De façon particulière, l'échangeur de chaleur correspond à un caloduc ou à un dispositif à effet Peltier.

De façon avantageuse, la plateforme d'accueil comporte une paroi transparente permettant à un utilisateur de voir un écran du dispositif électronique portable à travers ladite paroi.

De façon particulière, la plateforme d'accueil est réalisée dans un matériau opaque, de telle façon qu'un utilisateur ne puisse pas voir le dispositif électronique portable à l'intérieur de la plateforme d'accueil lorsque moyen de fermeture étanche à l'air est en position fermée.

De façon avantageuse encore, la plateforme d'accueil comporte un écran extérieur configuré pour recopier un affichage d'un écran du dispositif électronique portable lorsque celui-ci est inséré dans la plateforme d'accueil.

Dans un mode de réalisation, la plateforme d'accueil comporte des moyens de connexion du dispositif électronique portable à un réseau de communication de l'aéronef.

Dans un mode de réalisation, la plateforme d'accueil comporte des moyens de connexion du dispositif électronique portable à une interface homme-machine de l'aéronef. Cela permet de contrôler le dispositif électronique portable au moyen d'un dispositif de saisie (par exemple un clavier et/ou un trackball) de l'interface homme-machine et/ou de visualiser, au moyen d'un écran de l'interface homme-machine, des informations issues du dispositif électronique portable.

Dans un mode de réalisation, la plateforme d'accueil comporte des moyens d'alimentation électrique du dispositif électronique portable.

L'invention est également relative à un aéronef comprenant une plateforme d'accueil tel que précitée.

### DESCRIPTION DETAILLEE :

L'invention sera mieux comprise à la lecture de la description qui suit et à l'examen des figures annexées.
La figure 1 représente un aéronef comportant un cockpit ;
La figure 2 est une vue en perspective simplifiée d'une plateforme d'accueil conforme à un mode de réalisation de l'invention ;
La figure 3, est une vue en coupe selon la ligne A - A de la figure 2.

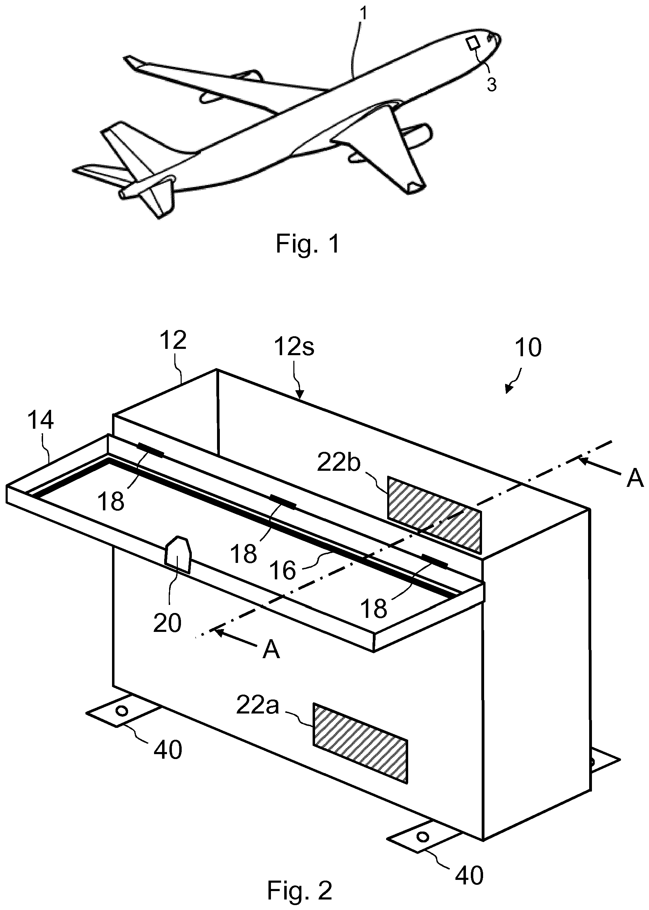

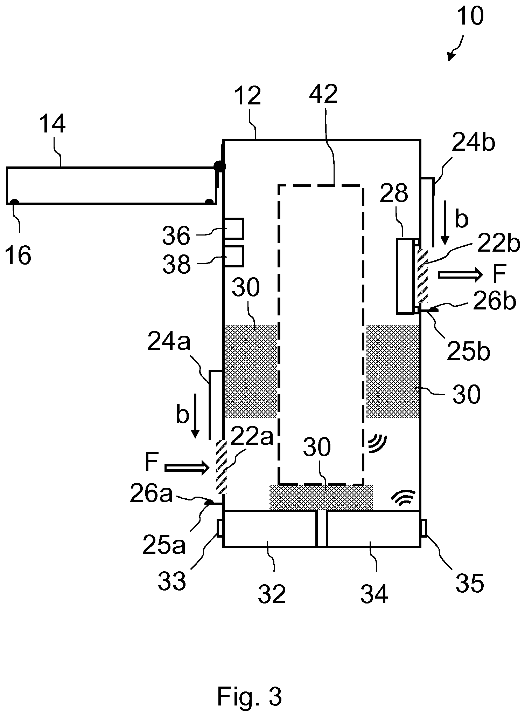

La plateforme d'accueil 10 représentée sur les figures 2 et 3 comporte un réceptacle 12 et un moyen de fermeture correspondant à un couvercle 14. Le couvercle 14 comporte un joint d'étanchéité 16 prévu pour coopérer avec une partie supérieure 12s du réceptacle 12. Ce couvercle 14 est articulé au réceptacle 12 au moyen d'un ensemble ce charnières 18 de telle façon qu'il peut occuper au moins une position ouverte, comme représenté sur les figures et une position fermée dans laquelle ce couvercle forme un moyen de fermeture étanche à l'air de la plateforme d'accueil 10. Un verrou 20 solidaire du couvercle 14 est prévu pour coopérer avec un moyen de verrouillage non représenté, solidaire du réceptacle 12, de façon à maintenir le couvercle 14 en position fermée. La plateforme d'accueil 10 comporte des moyens de fixation 40, par exemple des pattes de fixation, permettant de la fixer dans un cockpit 3 d'un aéronef 1 tel que celui représenté sur la figure 1. Le réceptacle 12 est prévu pour recevoir un dispositif électronique portable 42, tel par exemple qu'un ordinateur portable, une tablette tactile ou un téléphone portable intelligent.

Lorsque le couvercle 14 est en position ouverte, un membre d'équipage de l'aéronef peut insérer ou retirer le dispositif électronique portable 42 du réceptacle 12 de la plateforme d'accueil 10. Un fois le dispositif électronique portable 42 inséré dans le réceptacle 12, le membre d'équipage peut manœuvrer le couvercle 14 de façon à l'amener en position fermée. Le dispositif électronique portable 42 est ainsi enfermé dans la plateforme d'accueil 10 qui constitue une enceinte étanche à l'air. Cela permet de protéger le cockpit 3 de l'aéronef et les membres d'équipage en cas d'incendie et/ou d'émanation de fumées provenant du dispositif électronique portable.

La plateforme d'accueil 10 est prévue pour permettre l'utilisation du dispositif électronique portable 42 par un membre d'équipage lorsque le dispositif électronique portable 42 est inséré et enfermé dans la plateforme d'accueil 10.

Dans un mode de réalisation, la plateforme d'accueil 10 comporte des moyens de communication 34 prévus pour permettre au dispositif électronique portable 42, enfermé dans la plateforme d'accueil 10, de communiquer avec l'extérieur de la plateforme d'accueil 10. La communication entre le dispositif électronique portable 42 et les moyens de communication 34 peut être de type filaire ou de type sans fil (par exemple de type WiFi ou de type LiFi) comme représenté sur la figure 3. De façon avantageuse, les moyens de communication 34 sont configurés pour permettre une connexion du dispositif électronique portable à un réseau de communication de l'aéronef. Cette communication peut être de type sans fil (par exemple de type WiFi) ou de type filaire (par exemple de type Ethernet). Dans un tel cas, les moyens de communication 34 comportent un connecteur 35 permettant de les raccorder à ce réseau de communication de l'aéronef. De façon avantageuse encore, les moyens de communication 34 comprennent un commutateur et/ou un routeur. La connexion du dispositif électronique portable 42 au réseau de communication de l'aéronef permet l'acquisition, par le dispositif électronique portable 42 enfermé dans la plateforme d'accueil 10, d'informations issues de systèmes avioniques de l'aéronef. Cette connexion peut en outre permettre le contrôle du dispositif électronique portable 42 par des moyens de contrôle du cockpit 3, par exemple de type clavier et/ou trackball, ainsi qu'un report de l'affichage du dispositif électronique portable 42 sur un écran du cockpit 3 de l'aéronef.

Dans un mode particulier de réalisation, le réceptacle 12 comporte une paroi transparente permettant à un utilisateur tel qu'un membre d'équipage de voir un écran du dispositif électronique portable 42 à travers ladite paroi. Cette paroi transparente comporte avantageusement une surface tactile permettant d'interagir avec le dispositif électronique portable 42. Dans un autre mode particulier de réalisation, la plateforme d'accueil comporte un écran extérieur configuré pour recopier un affichage d'un écran du dispositif électronique portable 42 lorsque celui-ci est inséré dans la plateforme d'accueil. Cet écran est par exemple relié au dispositif électronique portable 42 via les moyens de communication 34. De façon avantageuse, cet écran est de type tactile, permettant au membre d'équipage de contrôler le dispositif électronique portable 42. Selon une alternative, cet écran est fixé directement sur la plateforme d'accueil 10. Selon une autre alternative, il est placé dans le cockpit 3 de l'aéronef et relié par une liaison filaire à la plateforme d'accueil 10. De façon particulière, notamment dans cet un autre mode particulier de réalisation, la plateforme d'accueil est réalisée dans un matériau opaque, de telle façon qu'un utilisateur ne puisse pas voir le dispositif électronique portable à l'intérieur de la plateforme d'accueil lorsque moyen de fermeture étanche à l'air est en position fermée. L'utilisateur visualise alors les informations issues du dispositif électronique portable sur un autre écran dans le cockpit, relié au dispositif électronique portable.

Dans un mode de réalisation, la plateforme d'accueil 10 comporte une alimentation électrique 32 recevant de l'énergie électrique d'un réseau électrique de l'aéronef, par exemple via un connecteur électrique 33. Cette alimentation électrique 32 est prévue pour alimenter électriquement le dispositif électronique portable 42 lorsque celui-ci est inséré dans le réceptacle 12. Le dispositif électronique portable 42 peut ainsi être utilisé même si sa batterie incorporée n'est pas suffisamment chargée. Selon une alternative, le dispositif électronique portable 42 est relié à l'alimentation électrique 32 par une liaison filaire, par exemple via un connecteur de type USB. Selon une autre alternative, le dispositif électronique portable 42 est couplé à l'alimentation électrique 32 de façon inductive, ce qui évite l'utilisation d'une liaison filaire.

De façon avantageuse, la plateforme d'accueil 10 est prévue pour évacuer la chaleur dissipée par le dispositif électronique portable 42. Pour cela, dans un premier mode de réalisation, la plateforme d'accueil 10 comporte un système de ventilation qui comprend un ensemble d'aérations permettant une circulation de l'air dans le réceptacle. Par exemple, comme représenté sur les figures 2 et 3, le réceptacle 12 comporte des aérateurs 22a, 22b. L'aérateur 22a est placé en partie inférieure d'une première face du réceptacle 12 et l'aérateur 22b est placé en partie supérieure d'une deuxième face du réceptacle, opposée à la première face, ce qui permet une circulation de l'air de l'aérateur 22a vers l'aérateur 22b, autour du dispositif électronique portable 42 comme illustré par les flèches F sur la figure 3. La chaleur dissipée par le dispositif électronique portable 42 est ainsi évacuée vers l'extérieur de la plateforme d'accueil 10. Les aérateurs 22a et 22b comprennent par exemple un ensemble de chicanes. De façon avantageuse, la plateforme d'accueil 10 peut en outre comporter un ventilateur 28 permettant d'améliorer la circulation d'air dans le réceptacle 12 entre l'aérateur 22a et l'aérateur 22b. La plateforme d'accueil 10 comporte en outre des moyens d'obturation des aérateurs 22a et 22b. Ces moyens d'obturation comprennent par exemple des premières parties 25a, 25b fixes par rapport au réceptacle 12 et des deuxièmes parties 24a, 24b mobiles par rapport au réceptacle 12 comme illustré par les flèches b. Dans leurs positions illustrées sur la figure 3, les deuxièmes parties 24a, 24b permettent le passage de l'air entre l'intérieur et l'extérieur de la plateforme d'accueil 10 à travers les aérateurs 22a, 22b, ce qui correspond à une première position, dite active, du système de ventilation, dans laquelle le système de ventilation permet une circulation d'air entre l'intérieur et l'extérieur de la plateforme d'accueil. Les deuxièmes parties 24a, 24b peuvent être translatées selon les flèches b de telle sorte qu'une extrémité desdites deuxièmes parties 24a, 24b vienne en contact respectivement avec les premières parties 25a, 25b. De façon avantageuse, les premières parties 25a, 25b sont munies d'un joint d'étanchéité respectivement 26a, 26b. Les moyens d'obturation obstruent alors le passage de l'air en regard des aérateurs 22a, 22b, ce qui correspond à une deuxième position, dite inactive, du système de ventilation dans laquelle le système de ventilation empêche la circulation d'air entre l'intérieur et l'extérieur de la plateforme d'accueil.

Le système de ventilation est ainsi commandable entre d'une part la première position, active, dans laquelle il permet une circulation d'air entre l'intérieur et l'extérieur de la plateforme d'accueil et d'autre part la deuxième position, inactive, dans laquelle il empêche la circulation d'air entre l'intérieur et l'extérieur de la plateforme d'accueil. Dans une première alternative, le système de ventilation comporte un moyen mécanique prévu pour commander manuellement une commutation entre sa position active et sa position inactive ou réciproquement. Ce moyen mécanique correspond par exemple à une poignée ou à un levier permettant de manœuvrer les deuxièmes parties 24a, 24b selon les flèches b représentées sur la figure 3. Ce moyen mécanique est avantageusement commun aux deux deuxièmes parties 24a et 24b. Il est toutefois possible de prévoir un moyen de commande individuel pour chacune des deuxièmes parties 24a et 24b. En fonctionnement normal, un membre d'équipage place le moyen mécanique de telle façon que le système de ventilation soit dans sa position active. Si le membre d'équipage détecte un début d'incendie du dispositif électronique portable ou une émanation de fumées, il actionne le moyen mécanique de façon à placer le système de ventilation dans sa position inactive. Le cockpit de l'aéronef est alors protégé de l'incendie ou de l'émanation de fumées.

Dans une deuxième alternative, le système de ventilation comporte un capteur prévu pour détecter une condition environnementale dégradée à l'intérieur de la plateforme d'accueil 10. Ce capteur correspond par exemple à un capteur de température 36 permettant de détecter une élévation de température et/ou à un capteur de fumée 38 permettant de détecter une émanation de fumée dans la plateforme d'accueil 10. Le système de ventilation comporte également un actionneur configuré pour commander la position active ou la position inactive du système de ventilation, ainsi qu'une unité de traitement. L'unité de traitement est reliée à une sortie du ou des capteur(s) 36, 38 et elle est configurée pour commander l'actionneur de façon à commander la position active du système de ventilation lorsque le(s) capteur(s) détecte(nt) une condition environnementale dégradée dans la plateforme d'accueil 10, telle qu'une élévation de température et/ou une émanation de fumée. Cela permet de protéger automatiquement le cockpit de l'aéronef en cas d'incendie ou d'émanation de fumées.

Dans un deuxième mode de réalisation, la plateforme d'accueil 10 comporte un échangeur de chaleur prévu pour évacuer la chaleur issue du dispositif électronique portable 42 vers l'extérieur de la plateforme d'accueil. Cet échangeur de chaleur est de préférence placé contre une paroi du réceptacle 12. Il correspond par exemple à un caloduc ou à un dispositif à effet Peltier. Un tel échangeur de chaleur présente l'avantage de ne pas nécessiter une circulation d'air entre l'intérieur et l'extérieur de la plateforme d'accueil.

Dans un mode particulier de réalisation, les parois du réceptacle 12 et du couvercle 14 sont métalliques de façon à permettre une faradisation au moins partielle de l'intérieur de la plateforme d'accueil. En variante, ces parois sont réalisées dans un matériau non métallique, par exemple un matériau composite, incorporant un treillis métallique ou recouvert d'un treillis métallique de façon à permettre une faradisation au moins partielle de l'intérieur de la plateforme d'accueil.

Dans un mode particulier de réalisation, le réceptacle 12 comporte en outre un ensemble de cales 30 permettant de maintenir en position le dispositif électronique portable 42. Ces cales sont par exemple réalisées dans un matériau souple tel que de la mousse, permettant en outre de protéger le dispositif électronique portable.

## Revendications

1. Plateforme d'accueil (10) pour accueillir un dispositif électronique portable (42) de type Electronic Flight Bag (EFB) dans un aéronef (1), la plateforme d'accueil étant prévue pour être fixée dans l'aéronef et telle qu'elle comporte un moyen de fermeture étanche à l'air (14) configuré pour occuper au moins une première position, dite ouverte, dans laquelle le dispositif électronique portable peut être inséré ou retiré de la plateforme d'accueil et, une deuxième position, dite fermée, dans laquelle le dispositif électronique portable peut être utilisé par un utilisateur dans l'aéronef lorsque le dispositif électronique portable est inséré dans la plateforme d'accueil, la plateforme d'accueil étant fixée dans l'aéronef,
ladite plateforme d'accueil étant **caractérisée en ce qu'**elle comporte un système de ventilation (24a, 24b, 25a, 25b, 26a, 26b) commandable entre une première position, dite active, dans laquelle le système de ventilation permet une circulation d'air entre l'intérieur et l'extérieur de la plateforme d'accueil et une deuxième position, dite inactive, dans laquelle le système de ventilation empêche la circulation d'air entre l'intérieur et l'extérieur de la plateforme d'accueil.

2. Plateforme d'accueil selon la revendication 1, **caractérisé en ce que** le système de ventilation comporte un moyen mécanique prévu pour commander manuellement une commutation entre sa position active et sa position inactive ou réciproquement.

3. Plateforme d'accueil selon la revendication 1, **caractérisé en ce que** le système de ventilation comporte :
- un capteur (36, 38) prévu pour détecter une condition environnementale dégradée à l'intérieur de la plateforme d'accueil ;
- un actionneur configuré pour commander la position active ou la position inactive du système de ventilation ; et
- une unité de traitement reliée à une sortie du capteur et configurée pour commander l'actionneur de façon à commander la position active du système de ventilation lorsque le capteur détecte une condition environnementale dégradée.

4. Plateforme d'accueil selon l'une quelconque des revendications précédentes, **caractérisé en ce qu'**elle comporte un échangeur de chaleur prévu pour évacuer la chaleur issue du dispositif électronique portable (42) vers l'extérieur de la plateforme d'accueil.

5. Plateforme d'accueil selon l'une quelconque des revendications précédentes, **caractérisée en ce qu'**elle comporte une paroi transparente permettant à un utilisateur de voir un écran du dispositif électronique portable (42) à travers ladite paroi.

6. Plateforme d'accueil selon l'une quelconque des revendications 1 à 4, **caractérisée en ce qu'**elle comporte un écran extérieur configuré pour recopier un affichage d'un écran du dispositif électronique portable lorsque celui-ci est inséré dans la plateforme d'accueil.

7. Plateforme d'accueil selon l'une quelconque des revendications 1 à 4 ou 6, **caractérisée en ce qu'**elle est réalisée dans un matériau opaque, de telle façon qu'un utilisateur ne puisse pas voir le dispositif électronique portable à l'intérieur de la plateforme d'accueil lorsque moyen de fermeture étanche à l'air est en position fermée.

8. Plateforme d'accueil selon l'une quelconque des revendications précédentes, **caractérisée en ce qu'**elle comporte des moyens de connexion (34) du dispositif électronique portable à un réseau de communication de l'aéronef.

9. Plateforme d'accueil selon l'une quelconque des revendications précédentes, **caractérisée en ce qu'**elle comporte des moyens de connexion (34) du dispositif électronique portable à une interface homme-machine de l'aéronef.

10. Plateforme d'accueil selon l'une quelconque des revendications précédentes, **caractérisée en ce qu'**elle comporte des moyens d'alimentation électrique (32) du dispositif électronique portable.

11. Aéronef (1), comprenant une plateforme d'accueil (10) selon l'une quelconque des revendications 1 à 10.

## Patentansprüche

1. Aufnahmeplattform (10) für die Aufnahme einer tragbaren elektronischen Vorrichtung (42) vom Typ Electronic Flight Bag (EFB) in einem Luftfahrzeug (1), wobei die Aufnahmeplattform dafür vorgesehen ist, in dem Luftfahrzeug befestigt zu werden, und so beschaffen ist, dass sie ein Mittel zum luftdichten Verschließen (14) aufweist, das dafür ausgelegt ist, wenigstens eine erste, sogenannte offene Position einzunehmen, in welcher die tragbare elektronische Vorrichtung in die Aufnahmeplattform eingesetzt oder aus ihr entnommen werden kann, und eine zweite, sogenannte geschlossene Position, in welcher die tragbare elektronische Vorrichtung von einem Benutzer im Luftfahrzeug verwendet werden kann, wenn die tragbare elektronische Vorrichtung in die Aufnahmeplattform eingesetzt ist, während die Aufnahmeplattform im Luftfahrzeug befestigt ist, wobei die Aufnahmeplattform **dadurch gekennzeichnet ist, dass** sie ein Belüftungssystem (24a, 24b, 25a, 25b, 26a, 26b) aufweist, das zwischen einer ersten, sogenannten aktiven Position, in welcher das Belüftungssystem eine Luftzirkulation zwischen dem Inneren und dem Äußeren der Aufnahmeplattform ermöglicht, und einer zweiten, sogenannten inaktiven Position, in welcher das Belüftungssystem die Luftzirkulation zwischen dem Inneren und dem Äußeren der Aufnahmeplattform verhindert, steuerbar ist.

2. Aufnahmeplattform nach Anspruch 1, **dadurch gekennzeichnet, dass** das Belüftungssystem ein mechanisches Mittel aufweist, das dafür vorgesehen ist, eine Umschaltung zwischen seiner aktiven Position und seiner inaktiven Position oder umgekehrt manuell zu steuern.

3. Aufnahmeplattform nach Anspruch 1, **dadurch gekennzeichnet, dass** das Belüftungssystem aufweist:
- einen Sensor (36, 38), der dafür vorgesehen ist, eine verschlechterte Umgebungsbedingung im Inneren der Aufnahmeplattform zu erkennen;
- einen Aktuator, der dafür ausgelegt ist, die aktive Position oder die inaktive Position des Belüftungssystems anzusteuern; und
- eine Verarbeitungseinheit, die mit einem Ausgang des Sensors verbunden ist und dafür ausgelegt ist, den Aktuator so zu steuern, dass er die aktive Position des Belüftungssystems ansteuert, wenn der Sensor eine verschlechterte Umgebungsbedingung erkennt.

4. Aufnahmeplattform nach einem der vorhergehenden Ansprüche, **dadurch gekennzeichnet, dass** sie einen Wärmetauscher aufweist, der dafür vorgesehen ist, die von der tragbaren elektronischen Vorrichtung (42) abgegebene Wärme zur Außenseite der Aufnahmeplattform abzuleiten.

5. Aufnahmeplattform nach einem der vorhergehenden Ansprüche, **dadurch gekennzeichnet, dass** sie eine durchsichtige Wand aufweist, die einem Benutzer ermöglicht, einen Bildschirm der tragbaren elektronischen Vorrichtung (42) durch diese Wand hindurch zu sehen.

6. Aufnahmeplattform nach einem der Ansprüche 1 bis 4, **dadurch gekennzeichnet, dass** sie einen äußeren Bildschirm aufweist, der dafür ausgelegt ist, eine Anzeige eines Bildschirms der tragbaren elektronischen Vorrichtung zu kopieren, wenn diese in die Aufnahmeplattform eingesetzt ist.

7. Aufnahmeplattform nach einem der Ansprüche 1 bis 4 oder 6, **dadurch gekennzeichnet, dass** sie aus einem lichtundurchlässigen Material hergestellt ist, derart, dass ein Benutzer die tragbare elektronische Vorrichtung im Inneren der Aufnahmeplattform nicht sehen kann, wenn sich das Mittel zum luftdichten Verschließen in der geschlossenen Position befindet.

8. Aufnahmeplattform nach einem der vorhergehenden Ansprüche, **dadurch gekennzeichnet, dass** sie Mittel zum Anschluss (34) der tragbaren elektronischen Vorrichtung an ein Kommunikationsnetz des Luftfahrzeugs aufweist.

9. Aufnahmeplattform nach einem der vorhergehenden Ansprüche, **dadurch gekennzeichnet, dass** sie Mittel zum Anschluss (34) der tragbaren elektronischen Vorrichtung an eine Mensch-Maschine-Schnittstelle des Luftfahrzeugs aufweist.

10. Aufnahmeplattform nach einem der vorhergehenden Ansprüche, **dadurch gekennzeichnet, dass** sie Mittel zur Stromversorgung (32) der tragbaren elektronischen Vorrichtung aufweist.

11. Luftfahrzeug (1), welches eine Aufnahmeplattform (10) nach einem der Ansprüche 1 bis 10 umfasst.

## Claims

1. Support platform (10) for accommodating a portable electronic device (42) of Electronic Flight Bag (EFB) type in an aircraft (1), the support platform being designed to be fixed in the aircraft and such in that it comprises an airtight closure means (14) configured to occupy at least a first, so-called open position, in which the portable electronic device can be inserted in or removed from the support platform, and a second, so-called closed position, in which the portable electronic device can be used by a user in the aircraft when the portable electronic device is inserted into the support platform, the support platform being fixed in the aircraft,
said support platform being **characterized in that** it comprises a cooling system (24a, 24b, 25a, 25b, 26a, 26b) that can be commanded between a first, so-called active position, in which the cooling system allows a circulation of air between the interior and the exterior of the support platform, and a second, so-called inactive position, in which the cooling system prevents the circulation of air between the interior and the exterior of the support platform.

2. Support platform according to Claim 1, **characterized in that** the cooling system comprises a mechanical means provided to manually command a switchover between its active position and its inactive position or vice versa.

3. Support platform according to Claim 1, **characterized in that** the cooling system comprises:
- a sensor (36, 38) provided to detect a degraded environmental condition inside the support platform;
- an actuator configured to command the active position or the inactive position of the cooling system; and
- a processing unit linked to an output of the sensor and configured to command the actuator so as to command the active position of the cooling system when the sensor detects a degraded environmental condition.

4. Support platform according to any one of the preceding claims, **characterized in that** it comprises a heat exchanger provided to discharge the heat from the portable electronic device (42) out of the support platform.

5. Support platform according to any one of the preceding claims, **characterized in that** it comprises a transparent wall allowing a user to see a screen of the portable electronic device (42) through said wall.

6. Support platform according to any of Claims 1 to 4, **characterized in that** it comprises an outer screen configured to copy a display of a screen of the portable electronic device when the latter is inserted into the support platform.

7. Support platform according to any one of Claims 1 to 4 or 6, **characterized in that** it is produced in an opaque material, in such a way that a user cannot see the portable electronic device inside the support platform when airtight closure means is in closed position.

8. Support platform according to any one of the preceding claims, **characterized in that** it comprises means (34) for connecting the portable electronic device to a communication network of the aircraft.

9. Support platform according to any one of the preceding claims, **characterized in that** it comprises means (34) for connecting the portable electronic device to a human-machine interface of the aircraft.

10. Support platform according to any one of the preceding claims, **characterized in that** it comprises electrical power supply means (32) for the portable electronic device.

11. Aircraft (1), comprising a support platform (10) according to any one of Claims 1 to 10.
